# EUROPEAN PATENT SPECIFICATION

(11) **EP 2 303 957 B1**
(45) Date of publication and mention of the grant of the patent: **29.02.2012**
(21) Application number: 09790707.5
(22) Date of filing: 22.07.2009
(51) Int. Cl.: C08K 3/08, H01L 31/0224, C08L 71/00

(54) **POLYMER THICK FILM SILVER ELECTRODE COMPOSITION FOR USE IN THIN-FILM PHOTOVOLTAIC CELLS**
POLYMERDICKFILM-SILBERELEKTRODENZUSAMMENSETZUNG ZUR VERWENDUNG IN DÜNNFILM-PHOTOVOLTAIKZELLEN
COMPOSITION POUR ÉLECTRODE D ARGENT EN COUCHE ÉPAISSE DE POLYMÈRE DESTINÉE À ÊTRE UTILISÉE DANS LES CELLULES PHOTOVOLTAÏQUES EN COUCHE MINCE

(30) Priority: 22.07.2008 US 82524 P
(43) Date of publication of application: 06.04.2011
(73) Proprietor: E. I. du Pont de Nemours and Company, Wilmington, DE 19898 (US)
(72) Inventor: DORFMAN, Jay, Robert, Durham North Carolina 27713 (US)
(74) Representative: Hoffmann, Benjamin
(86) International application number: PCT/US2009/051357
(87) International publication number: WO 2010/011719

(56) References cited:
- EP-A- 0 454 005
- EP-A- 1 541 654
- US-A- 5 006 575
- US-A- 5 049 313
- US-A- 5 051 208

## Description

### FIELD OF THE INVENTION

The invention is directed to a polymer thick film (PTF) silver conductor composition for use in Thin-Film photovoltaic cells. In one embodiment, the PTF silver composition is used as a screen-printed grid on top of a Transparent Conductive Oxide (TCO) such as Indium Tin Oxide.

### SUMMARY OF THE INVENTION

The invention is directed to a polymer thick film composition comprising: (a) silver flake (b) organic medium comprising (1) organic polymeric binder; (2) solvent; and (3) printing aids. The composition may be processed at a time and temperature necessary to remove all solvent. The silver flakes may be 76.0-92.0 weight percent of the total composition, the phenoxy resin may be 2.0 to 6.5 weight percent of the total composition, and the organic medium may be 8.0-24.0 weight percent of the total composition.

The invention is further directed to method(s) of electrode grid formation on Thin-Film Photovoltaic Cells using such compositions and to articles formed from such methods and/or compositions.

### DETAILED DESCRIPTION OF INVENTION

The invention describes a polymer thick film silver composition for use in Thin-Film Photovoltaic (PV) cells. It is typically used so as to improve the electrical efficiency of the cell. A grid-like pattern of Ag is printed on top of the Transparent Conductive Oxide (TCO). Thin-film PV cells are usually characterized by a light-absorbing semiconductor such as amorphous silicon, Copper Indium Gallium Diselenide (CIGS), or Cadmium Telluride. This distinguishes them from the traditional crystalline silicon-based PV cells. Thin-film refers to the thickness of the semiconductor which is typically 2 microns or so for the Thin-Film cells as opposed to 30-50 microns for crystalline silicon. Another difference between Thin-Film and c-Silicon PV cells is the temperature limitations involved. Thin-Film cells must be processed at less than 200 °C as the semiconductor and/or the substrate used in Thin-Film cannot withstand high temperatures. The traditional c-Silicon PV cells may be processed at temperatures up to 800 °C. Thus, the use of a PTF Ag composition as the top electrode grid is required as PTF compositions themselves are only stable up to approximately 200 °C.

Generally, a thick film composition comprises a functional phase that imparts appropriate electrically functional properties to the composition. The functional phase comprises electrically functional powders dispersed in an organic medium that acts as a carrier for the functional phase. Generally, the composition is fired to bum out the organics and to impart the electrically functional properties. However, in the case of polymer thick film, the organics remain as an integral part of the composition after drying. Prior to firing, a processing requirement may include an optional heat treatment such as drying, curing, reflow, and others known to those skilled in the art of thick film technology. "Organics" comprise polymer or resin components of a thick film composition.

The main components of the thick film conductor composition are a conductive powder dispersed in an organic medium, which includes polymer resin and solvent. The components are discussed herein below.

### A. Conductive Powder

In an embodiment, the conductive powders in the present thick film composition are Ag conductor powders and may comprise Ag metal powder, alloys of Ag metal powder, or mixtures thereof. Various particle diameters and shapes of the metal powder are contemplated. In an embodiment, the conductive powder may include any shape silver powder, including spherical particles, flakes (rods, cones, plates), and mixtures thereof. In an embodiment, the conductive powder may include silver flakes.

In an embodiment, the particle size distribution of the conductive powders may be 1 to 100 microns; in a further embodiment, 2-10 microns.

In an embodiment, the surface area/weight ratio of the silver particles may be in the range of 0.1-2.0 m²/g. In a further embodiment, the surface area/weight ratio of the silver particles may be in the range of 0.3-1.0 m²/g. In a further embodiment, the surface area/weight ratio of the silver particles may be in the range of 0.4-0.7 m²/g.

Furthermore, it is known that small amounts of other metals may be added to silver conductor compositions to improve the properties of the conductor. Some examples of such metals include: gold, silver, copper, nickel, aluminum, platinum, palladium, molybdenum, tungsten, tantalum, tin, indium, lanthanum, gadolinium, boron, ruthenium, cobalt, titanium, yttrium, europium, gallium, sulfur, zinc, silicon, magnesium, barium, cerium, strontium, lead, antimony, conductive carbon, and combinations thereof and others common in the art of thick film compositions. The additional metal(s) may comprise up to about 1.0 percent by weight of the total composition.

In an embodiment, the silver flakes may be present at 76 to 92 wt %, 77 to 88 wt %, or 78 to 83 wt % of the total weight of the composition.

### B. Organic Medium

The powders are typically mixed with an organic medium (vehicle) by mechanical mixing to form a paste like composition, called "pastes", having suitable consistency and rheology for printing. A wide variety of inert liquids can be used as organic medium. The organic medium must be one in which the solids are dispersible with an adequate degree of stability. The rheological properties of the medium must be such that they lend good application properties to the composition. Such properties include: dispersion of solids with an adequate degree of stability, good application of composition, appropriate viscosity, thixotropy, appropriate wettability of the substrate and the solids, a good drying rate, and a dried film strength sufficient to withstand rough handling.

The polymer resin may include a phenoxy resin which allows high weight loading of silver flake and thus helps achieve both good adhesion to Indium Tin Oxide substrates and low contact resistivity, two critical properties for silver electrodes in Thin-Film Photovoltaic Cells. In an embodiment, the phenoxy resin may be 2.0 to 6.5 wt %, 2.2 to 5.9 wt %, or 2.5 to 5.7 wt % of the total weight of the composition. In an embodiment, the phenoxy resin may be 1.5 to 6 weight percent of the total composition.

Solvents suitable for use in the polymer thick film composition are recognized by one of skill in the art and include acetate and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In an embodiment, the solvent may include one or more components selected from the group consisting of: Diethylene Glycol Ethyl Ether Acetate (carbitol acetate), DiBasic Ester, and C-11 Ketone. In addition, volatile liquids for promoting rapid hardening after application on the substrate may be included in the vehicle. In many embodiments of the present invention, solvents such as glycol ethers, ketones, esters and other solvents of like boiling points (in the range of 180°C to 250°C), and mixtures thereof may be used. The preferred mediums are based on glycol ethers and β-terpineol. Various combinations of these and other solvents are formulated to obtain the viscosity and volatility requirements desired.

Although screen-printing is expected to be a common method for the deposition of polymer thick film silver, any other conventional methods including stencil printing, syringe dispensing or other deposition or coating techniques may be utilized.

In an embodiment, the organic medium may be present at 8.0 to 24.0 wt %, 10.0 to 22.0 wt %, or 12.0 to 21.0 wt % of the total weight of the composition.

In an embodiment, the ratio of Ag to phenoxy resin may be between 13:1 and 35:1. In a further embodiment, the ratio of Ag to phenoxy resin may be between 15:1 and 30:1.

### Application of Thick Films

The polymer thick film silver composition also known as a "paste" is typically deposited on a substrate, such as sputtered polyester, that is impermeable to gases and moisture. The substrate can also be a sheet of flexible material, such as an impermeable plastic such as polyester, for example polyethylene terephthalate, or a composite material made up of a combination of plastic sheet with optional metallic or dielectric layers deposited thereupon. In one embodiment, the substrate can be a build-up of layers with metalized (stainless steel) polyester followed by the semiconductor layer (CIGS, for example), followed by a thin CdS layer, followed by sputtered Indium Tin Oxide. In another embodiment, Zinc Oxide may be used in place of Indium Tin Oxide as the Transparent Conductive Oxide (TCO) of the Thin-Film Solar Cell.

The deposition of the polymer thick film silver composition is performed preferably by screen printing, although other deposition techniques such as stencil printing, syringe dispensing or coating techniques can be utilized. In the case of screen-printing, the screen mesh size controls the thickness of deposited thick film.

The deposited thick film is dried by exposure to heat for typically 10-15 min at 140 °C, thus forming a thin-film solar cell.

The present invention will be discussed in further detail by giving practical examples. The scope of the present invention, however, is not limited in any way by these practical examples.

### EXAMPLE 1

The PTF silver electrode paste was prepared by mixing silver flake with an average particle size of 7 µm (range was 2-15 microns) with an organic medium composed of polyhydroxyether resin (also known as Phenoxy resin) available from Phenoxy Associates, Inc. The molecular weight of the resin was approximately 20,000. A solvent was used to dissolve the phenoxy resin completely prior to adding the silver flake. That solvent was Carbitol Acetate (Eastman Chemical).

The composition silver conductor C is given below:

| | |
|---|---|
| 81.55 wt % | Flaked Silver |
| 15.53 wt % | Organic Medium (23.0 wt % phenoxy resin/77.0 wt % solvent) |
| 2.92 wt % | Carbitol Acetate Solvent |

This composition was mixed for 30 minutes on a planetary mixer. The composition was then transferred to a three-roll mill where it was subjected to two passes at 100 and 200 psi. At this point, the composition was used to screen print a silver grid pattern on top of Indium Tin Oxide (80 ohm/sq resistivity) sputtered polyester. Using a 280 mesh stainless steel screen, a series of lines were printed, and the silver paste was dried at 150C for 15 min. in a forced air box oven. The contact resistivity was then measured as 2 x 10 -3 ohm cm2. As a comparison, a standard composition such as silver conductor A could not be measured as it has poor adhesion to ITO. Another standard product such as silver conductor B showed 3 x 10 -1 ohm cm2. This unexpected large improvement in contact resistivity for silver conductor C, a key property for Thin-Film PV silver compositions, enables it to be used for most applications and improves PV cell efficiency. A summary table appears below:

**Table 1**

| Silver Composition | Adhesion to ITO | Contact Resistivity |
|---|---|---|
| Silver conductor A | 1 | 3 x 10 -1 ohm cm2 |
| Silver conductor B | 1 | Cannot be Measured |
| Silver Conductor C | 5 | 2 x 10 -3 ohm cm2 |

### Comparative Example 2

PTF silver electrode paste D was prepared by mixing silver flake with an average particle size of 7 um with an organic medium composed of polyhydroxyether (Phenoxy resin) as per example 1. The solvent used was the same as in Example 1 (Carbitol Acetate). The composition of D is given below:

| | |
|---|---|
| 70.0 wt % | Flaked Silver |
| 29.0 wt % | Organic Medium (19.0 wt% phenoxy resin/81 wt % solvent) |
| 1.0 wt % | Carbitol Acetate Solvent |

The composition was mixed and roll-milled as per Example 1. The paste was screen-printed and dried exactly the same as indicated in Example 1. The contact resistivity measured was 8 x 10-1 ohm cm2 almost two orders of magnitude worse than silver conductor C. Adhesion to ITO was measured as clearly inferior to silver conductor C.

Additional compositions made and tested as described herein are shown in Table 2.

**Table 2**

| wt % Ag | wt % Resin | Ag/Resin | Contact R (mohm cm2) | Adhesion (To ITO) |
|---|---|---|---|---|
| 70.0 | 5.51 | 12.70 | 8 x 10 -1 | 1 |
| 73.0 | 6.75 | 10.81 | 2 x 10 -1 | 3 |
| 77.5 | 5.12 | 15.14 | 2 x 10 -3 | 5 |
| 81.5 | 3.57 | 22.83 | 1 x 10 -3 | 5 |
| 87.0 | 2.99 | 29.10 | 1 x 10 -3 | 5 |

In the examples herein, adhesion to ITO was measured using an ASTM Tape method. A 600 grade Tape was applied to a printed/dried pattern of silver ink. The tape was removed in a continuous fashion and the amount of silver ink material removed was estimated based upon an arbitrary scale of 1 to 5 with 5 representing no material removal (i.e. excellent adhesion).

In the examples herein, contact resistivity was measured by printing a series of silver lines on a Transparent Conductive Oxide

(Indium Tin Oxide) of varying spacing. The silver ink was dried under standard conditions. The Transmission Line Method was used to calculate the Contact R by plotting the Resistance of the lines vs. the spacing. The y-intercept then represents 2 x the Contact R.

## Claims

1. A composition comprising:
(a) a conductive composition comprising silver flakes, wherein the silver flakes are 76.0-92.0 weight percent of the total composition; dispersed in
(b) organic medium comprising (i) phenoxy resin, wherein the phenoxy resin is 2.0 to 6.5 weight percent of the total composition, dissolved in (ii) an organic solvent.

2. The composition of claim 1, wherein the organic medium is 8.0-24.0 weight percent of the total composition.

3. The composition of claim 1, wherein the phenoxy resin is 2.2-5.9 weight percent of the total composition.

4. The composition of claim 1, wherein the organic solvent comprises one or more components selected from the group consisting of: Diethylene Glycol Ethyl Ether Acetate (carbitol acetate), DiBasic Ester, and C-11 Ketone.

5. A method of forming a silver grid on a thin-film photovoltaic cell, comprising the steps of:
(a) applying the composition of claim 1 to a substrate, wherein the substrate is sputtered polyester;
(b) drying the composition on the substrate.

6. The method of claim 5, wherein the polyester is sputtered with indium tin oxide.

7. A thin-film photovoltaic cell comprising a silver grid line comprising the composition of claim 1.

8. A thin-film photovoltaic cell formed by the method of claim 5.

9. The method of claim 5, wherein the polyester is sputtered with zinc oxide.

## Patentansprüche

1. Zusammensetzung umfassend:
(a) eine leitfähige Zusammensetzung, die Silberflocken umfasst, wobei die Silberflocken 76,0 bis 92,0 Gewichtsprozent der gesamten Zusammensetzung ausmachen; dispergiert in
(b) einem organischen Medium, das (i) Phenoxyharz umfasst, wobei das Phenoxyharz 2,0 bis 6,5 Gewichtprozent der gesamten Zusammensetzung ausmacht, in (ii) einem organischen Lösungsmittel gelöst.

2. Zusammensetzung nach Anspruch 1, wobei das organische Medium 8,0 bis 24,0 Gewichtsprozent der gesamten Zusammensetzung ausmacht.

3. Zusammensetzung nach Anspruch 1, wobei das Phenoxyharz 2,2 bis 5,9 Gewichtsprozent der gesamten Zusammensetzung ausmacht.

4. Zusammensetzung nach Anspruch 1, wobei das organische Lösungsmittel eine oder mehrere Komponenten umfasst ausgewählt aus der Gruppe bestehend aus: Diethylenglykolethyletheracetat (Carbitolacetat), zweibasischem Ester und C-11-Keton.

5. Verfahren zum Bilden eines Silbergitters auf einer photovoltaischen Dünnfilmzelle, umfassend die Schritte des:
(a) Aufbringens der Zusammensetzung nach Anspruch 1 auf ein Substrat, wobei das Substrat besputterter Polyester ist;
(b) Trocknens der Zusammensetzung auf dem Substrat.

6. Verfahren nach Anspruch 5, wobei der Polyester mit Indium-Zinn-Oxid besputtert ist.

7. Photovoltaische Dünnfilmzelle, die eine Silbergitterlinie umfasst, die die Zusammensetzung nach Anspruch 1 umfasst.

8. Photovoltaische Dünnfilmzelle, die durch das Verfahren nach Anspruch 5 gebildet wird.

9. Verfahren nach Anspruch 5, wobei der Polyester mit Zinkoxid besputtert wird.

## Revendications

1. Composition comprenant:
(a) une composition conductrice comprenant des flocons d'argent, les flocons d'argent représentant 76,0 à 92,0 pour cent en poids de la composition totale; dispersés dans
(b) un milieu organique comprenant (i) une résine phénoxy, la résine phénoxy représentant 2,0 à 6,5 pour cent en poids de la composition totale, dissoute dans (ii) un solvant organique.

2. Composition selon la revendication 1, le milieu organique représentant 8,0 à 24,0 pour cent en poids de la composition totale.

3. Composition selon la revendication 1, la résine phénoxy représentant 2,2 à 5,9 pour cent en poids de la composition totale.

4. Composition selon la revendication 1, le solvant organique comprenant un ou plusieurs composant(s) choisi(s) parmi le groupe constitué de l'éthyl éther acétate de diéthylène glycol (acétate de carbitol), de l'ester dibasique, et d'une cétone en C-11.

5. Procédé de formation d'une grille en argent sur une cellule photovoltaïque à film fin, comprenant les étapes de:
(a) application de la composition selon la revendication 1 à un substrat, le substrat étant du polyester déposé par pulvérisation cathodique;
(b) séchage de la composition sur le substrat,

6. Procédé selon la revendication 5, le polyester étant déposé par pulvérisation cathodique avec de l'oxyde d'indium-étain.

7. Cellule photovoltaïque à film fin, comprenant une ligne de grille en argent comprenant la composition selon la revendication 1.

8. Cellule photovoltaïque à film fin formé selon le procédé selon la revendication 5.

9. Procédé selon la revendication 5, le polyester étant déposé par pulvérisation cathodique avec de l'oxyde de zinc.
